# EUROPEAN PATENT SPECIFICATION

(11) **EP 1 427 061 B1**
(45) Date of publication and mention of the grant of the patent: **20.04.2011**
(21) Application number: 04002034.9
(22) Date of filing: 24.11.1999
(51) Int. Cl.: H01R 12/00

(54) **Differential signal electrical connectors**
Elektrischer Verbinder für Differenz-Signale
Connecteurs électriques pour signaux différentiels

(43) Date of publication of application: 09.06.2004
(62) Divisional of application: 99962856.3
(73) Proprietor: Amphenol Corporation, Wallingford, CT 06492 (US)
(72) Inventor: Cohen, Thomas S., New Hampshire (US); Gailus, Mark W., Sommerville 02143 Massachusetts (US); Stokoe, Philip T., Attleboro 02703 Massachusetts (US)
(74) Representative: Luckhurst, Anthony Henry William

(56) References cited:
- EP-A- 0 422 785
- EP-A- 0 622 871
- EP-A- 0 627 791
- WO-A-97/36349
- WO-A-99/09616
- US-A- 5 236 375
- US-A- 5 605 476

## Description

### Background of the Invention

The invention relates to electrical connectors and, more particularly, to modular electrical connectors that provide signal paths for differential signals between mother boards and daughter boards or other electrical components.

Specialized electrical connectors may be used to connect different components of an electrical system. Typically, such an electrical connector connects a large number of electrical signals between a series of daughter boards to a mother board. The mother and daughter boards are connected at right angles. The electrical connector is typically modular. For example, a flat, planar metallic lead frame contains several signal paths, each of which bends about a right angle within the plane of the metallic lead frame. The signal paths are assembled into an insulated housing that also contains a planar grounding plate that provides a ground path and provides isolation between signals. The module is further assembled with other similar modules to form a connector capable of connecting a large number of signals between components in an electrical system.

Typically, the connectors attach to a printed circuit board, e.g., a mother board, daughter board, or back-plane. Conducting traces in the printed circuit board connect to signal pins of the connectors so that signals may be routed between the connectors and through the electrical system. Connectors are also used in other configurations, e.g., for interconnecting printed circuit boards, and for connecting cables to printed circuit boards.

Electronic systems generally have become more functionally complex. By means of an increased number of circuits in the same space, which also operate at increased frequencies. The systems handle more data and require electrical connectors that are electrically capable of carrying these electrical signals. As signal frequencies increase there is a greater possibility of electrical noise being generated by the connector in forms such as reflections, cross-talk and electromagnetic radiation. Therefore, the electrical connectors are designed to control cross-talk between different signal paths, and to control the characteristic impedance of each signal path. In order to reduce signal reflections in a typical module, the characteristic impedance of a signal path is generally determined by the distance between the signal conductor for this path and associated ground conductors, as well as both the cross-sectional dimensions of the signal conductor and the effective dielectric constant of the insulating materials located between these signal and ground conductors.

Cross-talk between distinct signal paths can be controlled by arranging the various signal paths so that they are spaced further from each other and nearer to a shield plate, which is generally the grounding plate. Thus, the different signal paths tend to electromagnetically couple more to the ground conductor path, and less with each other. For a given level of cross-talk, the signal paths can be placed closer together when sufficient electromagnetic coupling to the ground conductors is maintained.

An early use of shielding is shown in Japanese patent disclosure 49-6543 by Fujitsu, Ltd. dated February 15, 1974. U.S. patents 4,632,476 and 4,806,107 (both assigned to AT&T Bell Laboratories) show connector designs in which grounding plates are used between columns of signal contacts. These patents describe connectors in which the grounding plates run parallel to the signal contacts through both the daughter board and the back-plane connectors. U.S. Patents 5,429,520, 5,429,521, 5,433,617, and 5,433,618 (all assigned to Framatome Connectors International) show a similar arrangement.

Another modular connector system is shown in US Patents 5,066,236 and 5,496,183 (both assigned to AMP, Inc.), which describe electrical modules having a single column of signal contacts and signal paths arranged in a single plane that parallels the grounding plate. In contrast, U.S. Patent 5,795,191, describes an electrical module having electrical signal paths arranged in two parallel planes that each couple to a different grounding plate.

WO 97 36349 discloses a modular connector that can be used for differential signals.

It appears that the foregoing electrical connectors are designed primarily with regard to single-ended signals. A single-ended signal is carried on a single signal-conducting path, with the voltage relative to a common ground reference set of conductors being the signal. For this reason, single-ended signal paths are very sensitive to any common-mode noise present on the common reference conductors. We have recognized that this presents a significant limitation on single-ended signal use for systems with growing numbers of higher frequency signal paths.

Further, existing high frequency high density connectors often require patterns and sizes of holes in the attached printed wiring boards (PWB) that limit the width and number of printed circuit signal traces that may be routed through the connector footprint portion of the PWB(s).

We have recognized that, predominantly in a printed circuit backplane, it is highly desirable to have the ability to route on each signal layer multiple traces in various directions between particular patterns, rows, or columns of holes in the connector footprint. We have also recognized that in higher frequency backplane applications, especially for long path lengths, the ability to route wider traces can be used to reduce conductor losses.

We have also recognized that better control of cross-talk can be obtained by designing connectors for differential signals. Differential signals are signals represented by a pair of conducting paths, called a "differential pair". The voltage difference between the conductive paths represents the signal.

Differential pairs are known in such applications as telephone wires and on some high speed printed circuit boards. In general, the two conducting paths of a differential pair are arranged to run near each other. If any other source of electrical noise is electromagnetically coupled to the differential pair, the effect on each conducting path of the pair should be similar. Because the signal on the differential pair is treated as the difference between the voltages on the two conducting paths, a common noise voltage that is coupled to both conducting paths in the differential pair does not affect the signal. This renders a differential pair less sensitive to cross-talk noise, as compared with a single-ended signal path. We have invented an electrical connector well suited for carrying differential pairs.

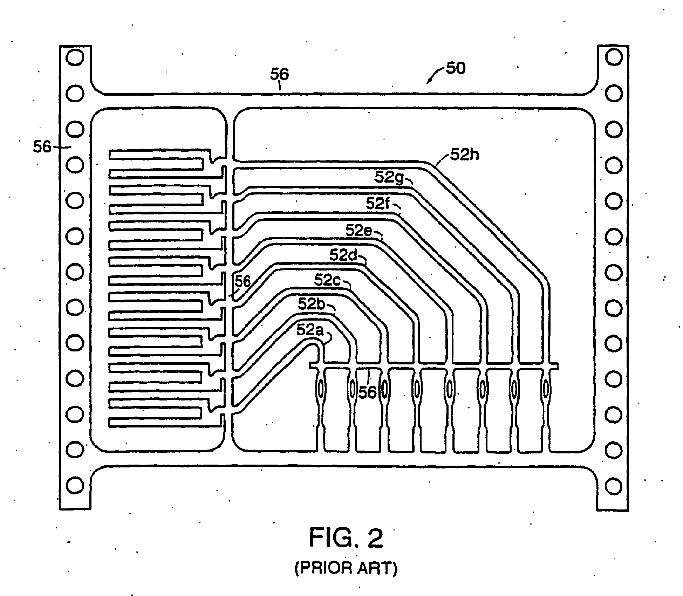

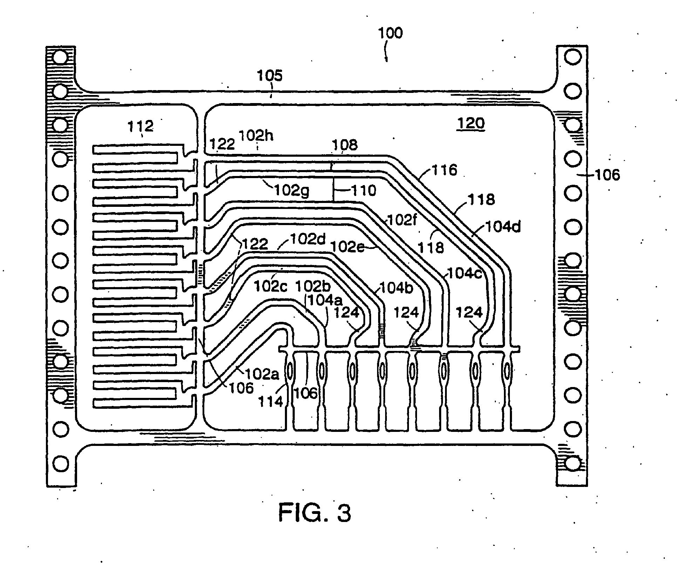

In addition, it is advantageous to have symmetrical, balanced electrical characteristics for the two conductive paths of a differential pair. Because current connectors have signal paths of different lengths (as shown in FIGS. 2 and 3), the electrical delay of each path is not equal, which can degrade the differential signal quality by inducing skew. It would be highly desirable to have a differential connector that has balanced paths.

Further, it would be desirable to have a differential connector module that is compatible with existing modular connector components. It would also be desirable to have a connector with a circuit board hole pattern that supports multiple wide signal traces and improved routability.

### Summary of the Invention

One aspect of the invention is an electrical connector module for transferring a plurality of differential signals between electrical components. The module has a plurality of pairs of signal conductors with a first signal path and a second signal path. Each signal path has a contact portion at each end of the signal path, and an interim section extending between the contact portions. For each pair of signal conductors, a first distance between the interim sections is less than a second distance between the pair of signal conductors and any other pair of signal conductors of the plurality.

Another aspect of the invention is an electrical connector module for conducting differential signals between electrical components, the connector module having opposing sides terminating along an edge. The module contains a pair of signal conductors optimized for coupling to the differential signal. The conductors are disposed in the module. Each one of the conductors has a contact portion that is laterally spaced along the edge of the module. Surface portions of the pair of conductors pass from the contact portions through the module in a substantially overlaying relationship along a direction extending through the sides of the module.

Each embodiment of the invention may contain one or more of the following advantages. The impedance of each differential signal path is matched. Each signal path of the pair of differential signal conductors is of equal electrical length. The pairs of differential signal paths can be spaced closer together. The spacing of each pair of differential signal conductors from other pairs reduces cross-taik within the connector. The pair of differential signal conductors can couple to the grounding plate to allow other pairs of differential signal conductors to be placed closer to the signal paths without inducing cross-talk. A portion of the grounding plate can extend between each of the pairs of differential signal conductors. Noise within each pair of differential signal conductors is reduced. The routing of signal traces is efficient. The grounding contact portions can extend between the contact portions of the signal conductors and allow the signal traces to extend in a direct path through a routing channel. The routing channel can be wide and straight

### Brief Description of the Drawings

FIG. 1 is a perspective view of a system according to the invention wherein a set of modular connectors are assembled between a mother board and a daughter board;
FIG. 2 is a schematic view of a prior art signal path metal lead frame that can be used in the assembly of a modular electrical connector wherein the signal paths are equally spaced and are not arranged in differential pairs;
FIG. 3 is a schematic view of a signal path metal lead frame that is used in the construction of a modular connector wherein the signal paths are arranged in pairs of differential signal conductors in a single plane;
FIG. 4 is a schematic view of still another embodiment of a signal path metal lead frame that is used in the construction of a modular connector wherein the signal paths are arranged in pairs of differential signal conductors in a single plane;
FIG. 5 is a perspective view of a grounding plate compatible for use with the signal path metal lead frame of FIG. 4, wherein contact portions of the grounding plate are extendable between contact portions of the signal path metal lead frame;
FIG. 5A is a perspective view of a pin header incorporating the grounding plate of FIG. 5;
FIG. 6 is a perspective view of an arrangement of signal paths according to the prior art wherein the signal paths are arranged In two parallel planes, each signal path in one plane inductively coupling with a first grounding plate (not shown) and each signal path in the other plane coupling with a second grounding plate (not shown);
FIG. 7 is a perspective view of another embodiment of signal paths arranged in pair of differential signal conductors, wherein the signal paths are arranged in two parallel planes;
FIG. 8 is a front view of yet another embodiment of signal paths arranged as a pair of differential signal conductors, wherein the signal paths are arranged in two parallel planes;
FIG. 9 is a side view of the signal paths of FIG. 8; FIG. 10 is a schematic view of connector module with balanced electrical properties;
FIG. 11A is a sketch illustrating a prior art circuit board signal launch; and FIG. 11B is a sketch illustrating an improved circuit board signal launch.

### Description of the Preferred Embodiments

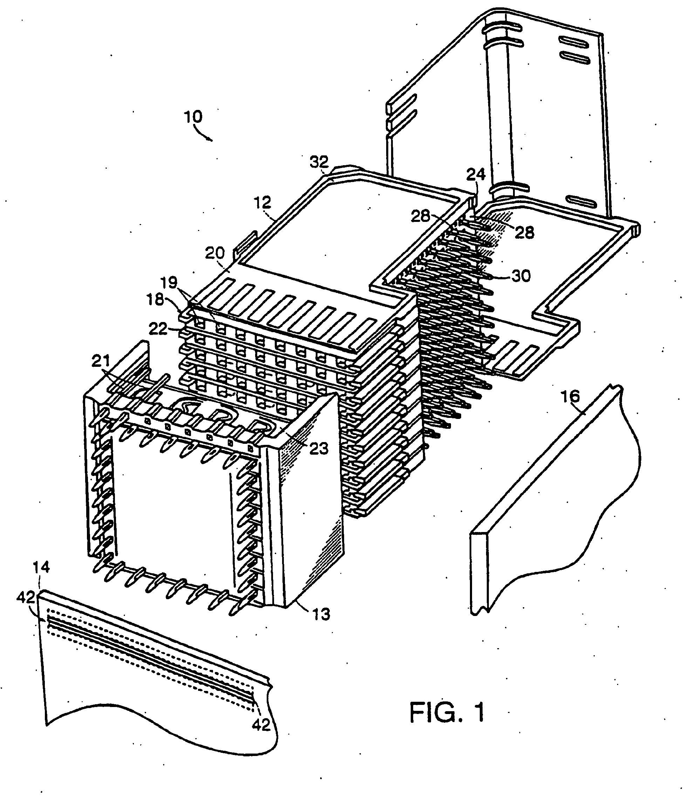

Referring to FIG. 1, an electrical system 10 includes a modular connector 12 that connects a backplane 14 to a daughter board 16. The connector 12 includes a plurality of connector modules 18 capable of connecting a set of electrical signals, either differential signals, non-differential signals, or both types of signals.

For example, if assembled as described below, the electrical connector module 18 can conduct a pair of differential electrical signals between electrical components of the system 10 such as the mother board 14 and the daughter board 16. Each connector module 18 has opposing sides 20, 22 that are aligned In parallel. The sides 20, 22 each terminate along an edge 24 of the connector module 18. (As shown, edge 24 is a planar surface section 28. However, other configurations are possible.) A set of connecting pins 28 extend from the edge 24. Grounding plates (not shown) may be placed between modules 18.

It should be noted that in a preferred embodiment, the openings 19 in each module 18 are evenly spaced. Likewise, the contact tails 28 are evenly spaced.

Referring to FIG. 2, a metal lead frame 50 defines eight non-differential signal paths 52a-52h for use in connector module 18. The metal lead frame 50 is stamped from a thin, metallic, planar member to include carrier strips 56 that support the signal paths 52a-52h prior to and during assembly of the electrical connector module 18. When the signal paths 52a-52h are fully integrated into the electrical connector module 18, support sections 56 are disconnected from the signal paths 52a-52h, and each signal path 52a-52h is disconnected from the other paths 52a-52h. U.S. Patent Application 08/797,540, High Speed, High Density Electrical Connector, filed February 7, 1997, discloses an electrical connector that Incorporates the metal lead frame 50.

Referring to FIG. 3, a similar metal lead frame 100, for use in module 18, defines eight signal paths 102a-102h. However, the paths 102a-102h are grouped into four pairs of differential signal conductors 104a-104d. The metal lead frame 100 is stamped with a thin, metallic, planar member that supports the signal paths 102a-102h prior to and during assembly of the electrical connector module 18. When the signal paths 102a-102h are fully integrated into the electrical connector module 18, support sections 106 are disconnected from the signal paths 102a-102h, and each signal path 102a-102h is disconnected from the other signal paths 102a-102h inside the electrical connector module 18.

Each one of the signal paths 102a-102h includes a pair of contact portions 112, 114, and an interim section 116 between the contact portions. The contact portions 112, 114 are connecting pins that connect the module 18 to the electrical components of the system 10. Contact portions 112 are shown as two parallel members. These members can be folded to form a box contact as in the prior art. The box contact acts as a receptacle for a pin 21 from the backplane. However, separable contact regions of many shapes are known and are not crucial to the invention.

In the present embodiment, the contact portions 112 of the signal paths 102a-102h are laterally and equidistantly spaced along the edge 118 of the metal lead frame 100. In a preferred embodiment, the spacing is 0.8mm (.030"). Typically, when attached as part of the system 10, the lateral spacing is In a vertical direction. Both the contact portions 112, 114 extend from the housing 32 of the module 18. The external structure of module 18 is identical to other modules which are not specifically designed to conduct differential signals. Therefore, the modules 18 are interchangeable with other modules, and the connector 12 can be configured with different types of modules which allow the connector 18 to conduct both differential and non-differential signals.

The interim sections 116 of each signal path 102a-102h are aligned in a single plane 120, typically a vertical plane. Therefore, surface portions 118 of each interim section 116 in the pair of conductors 104a-104d are substantially overlaid in the vertical plane.

The each signal path 102a-102h is coupled with a second signal path 102a-102h in pairs of differential signal conductors 104a-104d. For example, signal paths 102a, 102b form the pair of differential signal conductors 104a; the signal paths 102c, 102d form the pair of differential signal conductors 104b; the signal paths 102e, 102f form the pair of differential signal conductors 104c; the signal paths 102g, 102h form the pair of differential signal conductors 104d. Each signal path 102a-102h of each pair of differential signal conductors 104a-104d is coupled to the corresponding signal path 102a-102h of the pair 104a-104d. The coupling results because the distance 108 between the pairs of differential signal conductors 104a-104d is small relative to the distance 110 between adjacent pairs of differential signal conductors 104a-104d. The interim sections 116 of the pairs of signal conductors 104a-104d are arranged as close.together as possible whiles maintaining differential impedance. One of the interim sections 116 of each pair 104a-104d has curved sections 122, 124 that curves toward the other interim section 116 of the pair 104a-104d. Between the curved sections 122, 124, the pair of conductors 104a-104d tracks together along most of the interim sections 116.

The curved sections 122, 124 decrease the distance 108 between interim sections 116 of each pair 104a-104d, increase the distance 110 between adjacent pairs 104a-104d, and tend to equalize the length of each interim section 116 of the pair 104a-104d. This configuration improves the signal integrity for differential signals and decreases cross-talk between differential pairs 104a-104d and reduces signal skew.

Other embodiments are within the scope of the invention.

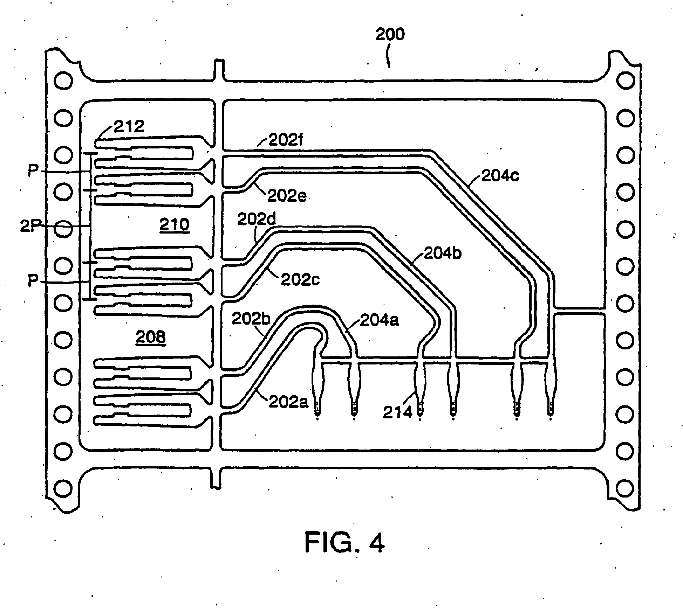

For example, referring to FIG. 4, a metal lead frame 200 includes six rather than eight signal paths 202a-202f. The signal paths are arranged in three pairs 204a-204c. In essence, metal lead frame 200 is identical to metal lead frame 100 except that the equivalent of two signal paths 102c, 102f have been removed. The remaining traces have to be aligned in pairs as before, with the spacing between the interim sections of the signal paths in a pair less than the spacing between the contact portions. Two spaces 208, 210, which are vacated by the signal paths 102c, 102f, lie between contact portions 214.

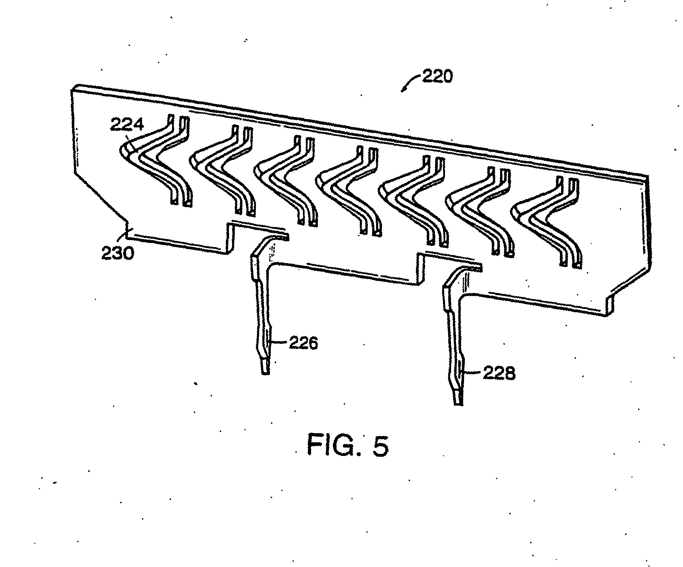

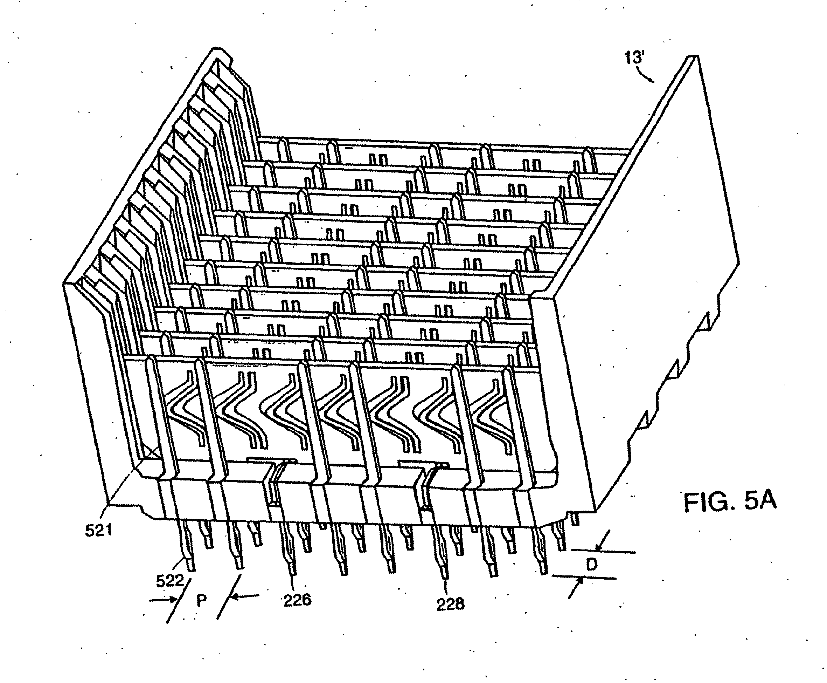

Referring also to FIG. 5, a grounding plate 220 contains a main body 230, resilient connecting tabs 224, and contact portions 226, 228. Grounding plate 220 is intended to be used in place of grounding plate 23 (FIG.1), particularly in conjunction with the embodiment of FIG. 4.

When a connector 12 is fully assembled and mated with connector 13, the grounding plate 220 is parallel to the signal paths 202a-202f. The contact portions 226, 288 are aligned with the contact portions 212 of the signal paths 202a-202f. The contact portions 226, 228 are each at corresponding right angles to the main body 230 and extend between the contact portions 212 within corresponding spaces 208, 210.

FIG. 5A shows the backplane module 13' including the grounding plate 220. There are columns of signal pins 521. Each column contains six signal pins 521, to correspond to the six mating contacts 212. There is no signal pin in backplane connector 13' corresponding to spaces 208 and 210 (FIG. 4). Rather, contact portions 226 and 228 are inserted into the spaces that correspond to-spaces 208 and 210. As a result, there are eight contact tails in each column - six corresponding to signal pins 521 and two being appending contact tails 226 and 228. The spacing between the contact tails is uniform, illustrated as dimension P in FIG. 5A.

This arrangement of contact tails means that the spacing between adjacent columns is a dimension D. The spacing D is dictated by the spacing between signal pairs 521 in adjacent columns.

By contrast, in backplane connector 13 (FIG. 1), the space between columns of contact tails for signal pins is occupied by contact tails for a grounding plate.

When a backplane connector is attached to backplane, a hole must be made for each contact tail. No signal traces can be routed in the backplane near holes. Thus, to space signal traces across a backplane, the traces generally run in the spaces between columns of contact tails. In the embodiment of FIG. 5A, the spacing D represents a wide routing channel for signal traces. Thus, the signal traces can be made wider and therefore have lower loss. The traces can also be made straighter because they do not have to jog around ground holes in the channels between signal contact tails. Straighter traces result in fewer impedance discontinuities, which are undesirable because they create reflections. This feature is particularly beneficial in a system carrying high frequency signals. Alternatively more traces could be routed in each layer, thereby reducing the number of layers and saving cost.

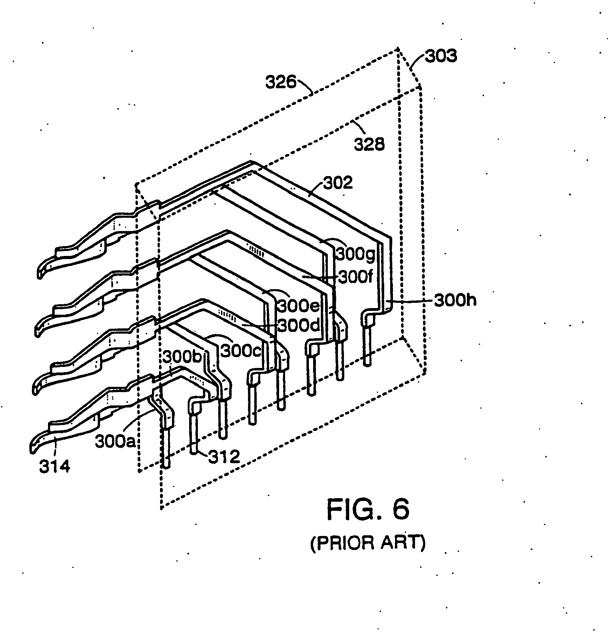

Referring to FIG. 6, a set of prior art signal paths 300a-300h for use in a modular electrical connector have interim sections 302 that are aligned along two different parallel planes 320, 322. Half of the interim sections are aligned along each corresponding plane. Contact portions 314 are aligned in a third central plane. Contact portions 312 lie in separate planes and are aligned with the third central plane. Thus, when fully assembled, each interim section 302 lies closer to a grounding plate than to another of signal paths 300a-300h.

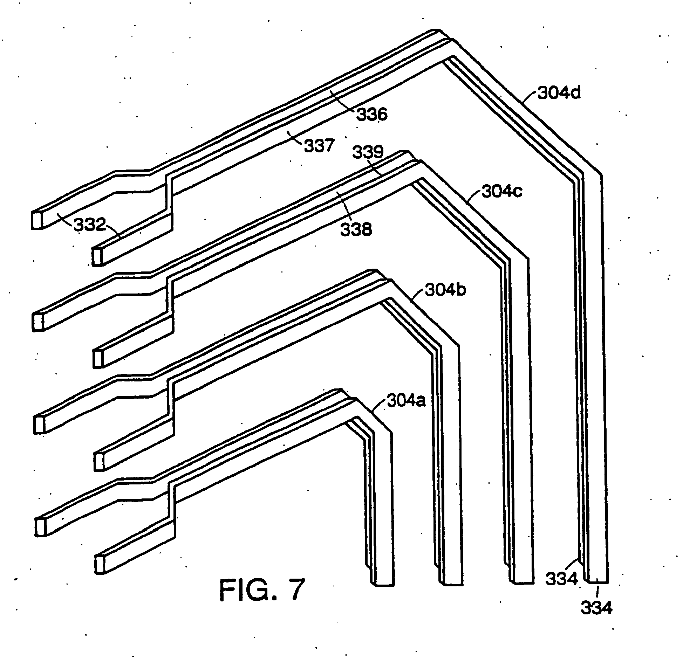

Referring also to FIG. 7, the signal paths of FIG. 6 are adapted to provide a set of differential signal conductors 304a-304d. Each conductor of the pairs 304a-304d includes a pair of contact portions 332, 334 and interim sections 336, 337 extending between contact portions 332, 334. Each pair of interim sections 336, 337 has a corresponding surface 338, 339 that overlays the other corresponding surface 338, 339. The surfaces 338, 339 overlay each other in a direction that extends through the sides 326, 328 of an electrical connection module 303, shown in FIG. 6. Thus, relative to the pairs 104a-104d of FIG. 3 which typically have overlying surfaces 118 in the vertical direction, the pairs 304a-304d typically have overlying surfaces 338, 339 in the horizontal direction. (The comparison between the pairs 104a-104d and the pairs 304a-304d is relative, and the surfaces 338 may overly in directions other than horizontal.)

However, unlike the paths 300a-300h depicted in FIG. 6, interim section 336 of each pair 304a-304d lies closer to corresponding interim section 337 of each pair 304a-304d than to a grounding plate or another pair of signal conductors 304a-304d. Therefore, each pair of conductors 304a-304d couples to the corresponding conductor of the pair 304a-304d to reduce noise.

The differential pairs of signal contacts will, preferably be held in an insulative housing, which is not shown. The contacts might be positioned as shown in FIG. 7 and then insulative material could be molded around the interim sections of the contacts. To achieve appropriate positioning of the contact members, a plastic carrier strip might be molded around the contact members in one plane. Then, the contact members in the other plane. might be overlaid on the carrier strip. Then, additional insulative material could be molded over the entire subassembly.

An alternative way to form an insulative housing around the contact members In the configuration shown in FIG. 7 would be to mold the housing in two interlocking pieces. One piece would contain the signal contacts In one plane. The other piece would contain the signal contacts in the other plane. The two pieces would then be snapped together to form a module with the signal contacts positioned as in FIG. 7. This manufacturing technique is illustrated in US patent 5,795,191. However, that patent does not recognize the desirability of positioning the interim sections of the signal contacts in the two places of the subassembly so that, when the two pieces are assembled, the signal contacts will overlay to create differential pairs.

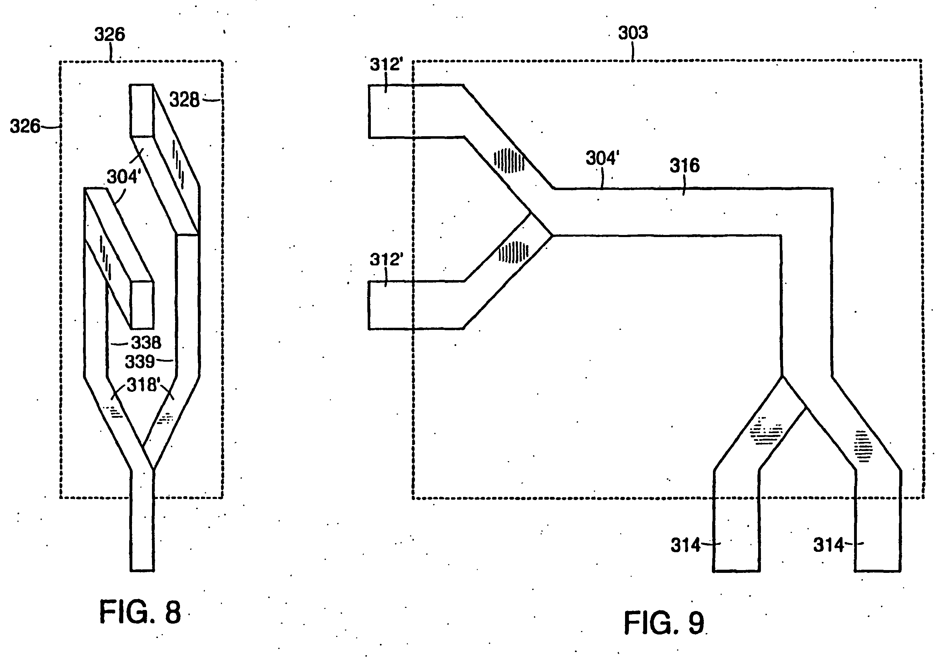

Referring also to FIGS. 8-9, an alternate arrangement of signal paths includes pairs of signal conductors 304' (here one pair being shown). Like the signal paths 300a-300h of FIG. 6, each conductor 304' of the pair extends toward the corresponding side 326, 328 of a module 303'. However, unlike the signal paths 300a-300h, surfaces 318' of the pair of signal conductors 304' are respectively jogged to have overlaying surfaces 338', 339' in a direction that is perpendicular to the sides 326, 328 of the module 303'. Thus, like the pairs of conductors of FIGS. 3, 4 and 7, the distance between conductors 304' is smaller than the distance from the pair of conductors 304' to other similar pairs of conductors. Also, like the contact portions 312 of FIG. 6, the contact portions 312', 314' all lie in a third central plane. In comparison, the contact portions 332 shown in FIG. 7 and contact portions 314 shown in FIG. 6 lie in two distinct planes.

As another alternative, it is not necessary that grounding plates be used with the differential connector modules as described above.

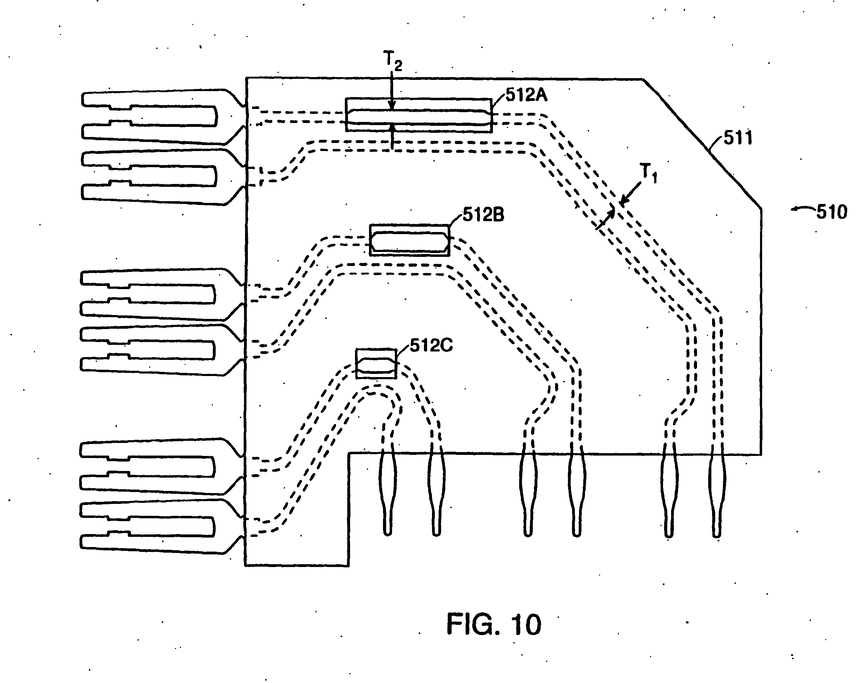

FIG. 10 shows an alternative embodiment for a differential connector module 510. As described above, a lead frame containing signal contacts is formed into a module by molding plastic 511 around the interim portions of the lead frame. In the module of FIG. 10, windows 512A, 512B and 512C are left in the plastic above the long lead in each pair. These windows serve to equalize the delay for signals traveling In the leads of each pair. As is known, the speed at which a signal propagates in a conductor is proportional to the dielectric constant of the material surrounding the conductor. Because air has a different dielectric constant than plastic, leaving the windows above the long leads, makes the signals in those leads move faster. As a result, the time for a signal to pass through the long lead and the short lead of the pair can be equalized.

The length of each window 512A...512C depends on the differential length between the long leg and the short leg of the pair. Thus, the size of the window could be different for each pair. Also, it is possible that multiple windows might be included for a pair. Further, it is not necessary that the window be filled with air. The window could be formed with a material having a different dielectric constant than the rest of plastic 511. For example, a plastic with a low dielectric constant could be molded over portions of the long contacts in each pair in the window regions. Then, a plastic with a higher dielectric constant could be over molded to form the plastic housing 511. Also, it is not necessary that the "window" extend all the way to the surface of the conducting signal contact. The "window" could be partially filled with plastic and partially filled with air, which would still have the effect of lowering the effective dielectric constant of the material above the long leg.

One drawback of placing a window in the dielectric material is that it also changes the impedance of the signal contact in the region below the window. Changes in impedance along a signal conductor are often undesirable because signal reflections occur at the discontinuities. To counter this problem, other adjustments can be made to keep the impedance constant along the length of the signal conductors. One way that the impedance can be kept constant is by changing the width of the signal conductors. In FIG. 10, the signal conductors are shown with a width of T₁ in one region and a broader width T₂ in the region of the windows. The exact dimensions are chosen to match the impedance based on the relative dielectric constant between the two regions. The technique of altering the width of the signal contacts in window regions is useful regardless of why the window is formed in the connector and is not limited to windows formed to equalize delay. For example, some prior art connectors use windows over substantial portions of all the signal contacts to increase impedance of all the signal contacts.

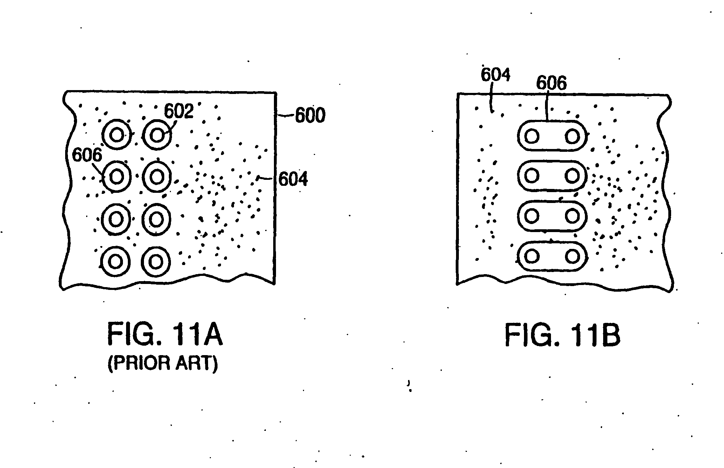

FIG. 11A and 11B show an alternative embodiment that can be used to increase the effectiveness of a differential connector. FIG. 11A illustrates a portion of a backplane 600 to which a connector might be attached. There are columns of holes 602 in backplane 600. The contact tails of the connector would be inserted into these holes to affix the connector to the backplane. One or more grounding plate layers 604 are included within backplane 600. The grounding plate layers are not deposited around the holes to avoid shorting out the connections made in the hole to leave exposed areas 606. However, in the prior art configuration shown in FIG. 11A, there is grounding plate material deposited between the holes 602. FIG. 11B shows a backplane printed circuit board adapted for use with a differential connector. Grounding plate layer 604 is deposited to leave an exposed area around the holes 602 that form a differential pair. In this way, there is no grounding plate layer between the two holes of a differential pair. Consequently, the common mode coupling between the two conducting elements of the differential pair is improved.

Also, it should be appreciated that numbers and dimensions are given herein. Those numbers are for illustration only and are not to be construed as limitations on the invention. For example, connectors with 6 and 8 rows are illustrated. However, any number of rows could be conveniently made.

Also, it was described that grounding plates could be used. Grounding members that are not plate shaped could also be used. The grounding members could be placed between pairs of conducting elements. In addition, the grounding plates do not need to be planar. In particular, FIG. 3 and FIG. 4 illustrate a connector configuration in which there are spaces between differential pair. To increase the isolation between the differential pairs, tabs could be cut out of the grounding plates and bent out of the plane of the plate to provide greater isolation between pairs.

It should also be recognized that the invention is illustrated by a right angle, press-fit, pin and socket connector. The invention is not useful simply in right angle applications. It could be used in stacking or mezzanine connectors. Nor is the invention limited to press-fit connectors. It could be used with surface mount or pressure mount connectors.

## Claims

1. An electrical connector module (18) for transferring a plurality of differential signals between electrical components (14, 16), the connector module comprising:
a plurality of pairs (104) of signal conductors (102), each pair having a first signal path and a second signal path, each signal path having a pair of contact portions (112,114), and an interim section (116) extending between the contact portions;
wherein for each pair of signal conductors (102) a first distance between the interim sections (116) is less than a second distance between the pair of signal conductors (102) and any other pair of signal conductors (102) of the plurality of pairs of signal conductors

2. The connector module of claim 1, wherein the interim section (116) of each first signal path is aligned in a first plane, and the interim section of each second signal path is aligned in a second plane spaced from the first plane.

3. The connector module of claim 1, wherein the interim section (116) of each first signal path and the interim section (116) of each second signal path are aligned in a plane.

4. The connector module of claim 1, wherein the interim sections of each pair (104) of signal conductors (102) have equal lengths.

5. The connector module of claim 1, wherein the interim sections of each pair (104) of signal conductors (102) track along a majority of the length of the interim sections.

6. The connector module of claim 1, wherein at least some of the paired signal paths are connected to a set of differential signals.

7. The connector module of claim 1, further comprising a grounding plate (220) spaced from the pairs (104) of signal conductors (102), the grounding plate providing a common ground signal path.

8. The connector module of claim 7, wherein the grounding plate (220) further comprises a main body (230) and a resilient tab (224), the resilient tab extending from the main body and between at least two pairs (104) of signal conductors (102).

9. The connector module of claim 7, wherein the grounding plate (220) further comprises a main body (230) and a grounding contact portion (226,228) extending from the main body (230).

10. The connector module of claim 9, wherein the grounding contact portion (226,228) is adjacent to the contact portions (112) of the signal paths.

11. The connector module of claim 9, wherein the grounding contact portion (226,228) extends between the contact portions (112) of the signal paths.

12. The connector module of claim 9, wherein the grounding contact portion (226,228) extends between adjacent contact portions (112) of two signal paths.

13. The connector module of claim 7, wherein the grounding plate (220) further comprises a main body (230) and a resilient tab (224), the resilient tab having ends connected to the main body (230), and the resilient tab extending from the main body.

14. The connector module of claim 13, wherein the resilient tab (224) has a curved shape between the ends.

15. The connector module of claim 16, further comprising an insulating member (32) extending along a portion of the grounding plate (220).

16. The connector module of claim 15, wherein the insulating member is a housing (32) external to the grounding plate (220) and the plurality of signal conductors (102).

## Patentansprüche

1. Elektrisches Steckverbindermodul (18) zum Weiterleiten einer Mehrzahl von Differenzsignalen zwischen elektrischen Bauteilen (14, 16), wobei das Steckverbindermodul Folgendes umfasst:
eine Mehrzahl von Paaren (104) von Signalleitern (102), wobei jedes Paar einen ersten Signalweg und einen zweiten Signalweg aufweist, wobei jeder Signalwege ein Paar Kontaktabschnitte (112, 114) und eine sich zwischen den Kontaktabschnitten erstreckende Zwischensektion (116) aufweist;
wobei, für jedes Paar von Signalleitern (102), eine erste Entfernung zwischen den Zwischensektionen (116) kleiner ist als eine zweite Entfernung zwischen dem Paar von Signalleitern (102) und jedwedem anderen Paar von Signalleitern (102) der Mehrzahl von Paaren von Sigzralleitern.

2. Steckverbindermodul nach Anspruch 1, wobei die Zwischensektion (116) jedes ersten Signalweges in einer ersten Ebene angeordnet ist, und die Zwischensektion jedes zweiten Signalweges in einer zweiten, von der ersten beabstandeten, Ebene angeordnet ist.

3. Steckverbindermodul nach Anspruch 1, wobei die Zwischensektion (116) jedes ersten Signalweges und die Zwischensektion (116) jedes zweiten Signalweges in einer Ebene angeordnet sind.

4. Steckverbindermodul nach Anspruch 1, wobei die Zwischensektionen jedes Paares (104) von Signalleitern (102) gleiche Längen haben.

5. Steckverbindermodul nach Anspruch 1, wobei die Zwischensektionen jedes Paares (104) von Signalleitern (102) entlang einem Hauptteil der Länge der Zwischensektionen verlaufen.

6. Steckverbindermodul nach Anspruch 1, wobei mindestens einige der gepaarten Signalwege mit einem Satz von Differenzsignalen verbunden sind.

7. Steckverbindermodul nach Anspruch 1, ferner umfassend eine Erdungsplatte (220), die mit Zwischenraum zu den Paare (104) von Signalleitern (102) angeordnet ist, wobei die Erdungsplatte einen gemeinsamen Erdungssignalweg bereitstellt.

8. Steckverbindermodul nach Anspruch 7, wobei die Erdungsplatte (220) ferner einen Hauptkörper (230) und eine nachgiebige Lasche (224) umfasst, wobei sich die nachgiebige Lasche vom Hauptkörper und zwischen mindestens zwei Paaren (104) von Signalleitern (102) erstreckt.

9. Steckverbindermodul nach Anspruch 7, wobei die Erdungsplatte (220) ferner einen Hauptkörper (230) und einen Erdungskontaktabschnitt (226, 228) umfasst, der sich vom Hauptkörper (230) aus erstreckt.

10. Steckverbindermodul nach Anspruch 9, wobei der Erdungskontaktabschnitt (226, 228) angrenzend an die Kontaktabschnitte (112, 114) der Signalwege angeordnet ist.

11. Steckverbindermodul nach Anspruch 9, wobei sich der Erdungskontaktabschnitt (226, 228) zwischen den Kontaktabschnitten (112) der Signalwege erstreckt.

12. Steckverbindermodul nach Anspruch 9, wobei sich der Erdungskontaktabschnitt (226, 228) zwischen aneinandergrenzenden Kontaktabschnitten (112) zweier Signalwege erstreckt.

13. Steckverbindermodul nach Anspruch 7, wobei die Erdungsplatte (220) ferner einen Hauptkörper (230) und eine nachgiebige Lasche (224) umfasst, wobei die Lasche Enden hat, die mit dem Hauptkörper (230) verbunden sind, und die nachgiebige Lasche sich vom Hauptkörper aus erstreckt.

14. Steckverbindermodul nach Anspruch 13, wobei die nachgiebige Lasche (224) zwischen ihren Enden bogenförmig ist.

15. Steckverbindermodul nach Anspruch 16, ferner umfassend ein isolierendes Element (32), das sich längs eines Abschnitts der Erdungsplatte (220) erstreckt.

16. Steckverbindermodul nach Anspruch 15, wobei das isolierende Element ein Gehäuse (32) außerhalb der Erdungsplatte (220) und der Mehrzahl von Signalleitern (102) ist.

## Revendications

1. Module de connecteur électrique (18) pour conduire une pluralité de signaux différentiels entre des composants électriques (14, 16), le module de connecteur comprenant:
une pluralité de paires (104) de conducteurs de signaux (102), chaque paire ayant un premier trajet de signal et un deuxième trajet de signal, chaque trajet de signal ayant une paire de parties de contact (112, 114), et une section intérimaire (116) s'étendant entre les parties de contact ;
dans lequel pour chaque paire de conducteurs de signaux (102) une première distance entre les sections intérimaires (116) est inférieure à une deuxième distance entre la paire de conducteurs de signaux (102) et toute autre paire de conducteurs de signaux (102) de la pluralité de paires de conducteurs de signaux.

2. Module de connecteur selon la revendication 1, dans lequel la section intérimaire (116) de chaque premier signal est alignée sur un premier plane, et la section intérimaire de chaque deuxième trajet de signal est aligné dans un deuxième plan espacé du premier plan.

3. Module de connecteur selon la revendication 1, dans lequel la section intérimaire (116) de chaque premier trajet de signal et la section intérimaire (116) de chaque deuxième trajet de signal sont alignés dans un plan.

4. Module de connecteur selon la revendication 1, dans lequel les sections intérimaires de chaque paire (104) de conducteurs de signaux (102) ont des longueurs égales.

5. Module de connecteur selon la revendication 1, dans lequel les sections intérimaires de chaque paire (104) de conducteurs de signaux (102) suivent la trajectoire de la plus grande partie de la longueur des sections intérimaires.

6. Module de connecteur selon la revendication 1, dans lequel au moins certaines des paires de trajets de signaux sont connectées à un groupe de signaux différentiels.

7. Module de connecteur selon la revendication 1, comprenant en outre une plaque de mise à la terre (220) espacée des paires (104) des conducteurs de signaux (102), la plaque de mise à la terre fournissant un trajet de signal de mise à la terre commue.

8. Module de connecteur selon la revendication 7, dans lequel la plaque de mise à la terre (220) comprend en outre un corps principal (230) et un élément résilient (224), l'élément résilient s'étendant depuis le corps principal et entre au moins deux paires (104) de conducteurs de signaux (102).

9. Module de connecteur selon la revendication 7, dans lequel la plaque de mise à la terre (220) comprend en outre un corps principal (230) et une partie de contact de mise à la terre (226, 228) s'étendant depuis le corps principal (230).

10. Module de connecteur selon la revendication 9, dans lequel la partie de contact de mise à la terre (226, 228) est adjacente aux parties de contact (112, 114) des trajets de signaux.

11. Module de connecteur selon la revendication 9, dans lequel la portion de contact de mise à la terre (226, 228) s'étend entre les parties de contact (112) des trajets de signaux.

12. Module de connecteur selon la revendication 9, dans lequel la partie de contact de mise à la terre (226, 228) s'étend entre les parties de contact adjacentes (112) de deux trajets de signaux.

13. Module de connecteur selon la revendication 7, dans lequel la plaque de mise à la terre (220) comprend en outre un corps principal (230) et une patte élastique (224), la patte élastique ayant les extrémités connectées au corps principal (230) et la patte élastique s'étendant à partir du corps principal.

14. Module de connecteur selon la revendication 13, dans lequel la patte élastique (224) a une forme courbe entre les extrémités.

15. Module de connecteur selon la revendication 16, comprenant en outre un élément d'isolation (32) s'étendant le long d'une partie de la plaque de mise à la terre (220).

16. Module de connecteur selon la revendication 15, dans lequel l'élément d'isolation est un boîtier (32) externe à la plaque de mise à la terre (220) et à la pluralité de conducteurs de signaux (102).
